Europäisches Patentamt

European Patent Office

Office européen des brevets

(11) Numéro de publication: **0 360 700**
**A1**

## DEMANDE DE BREVET EUROPEEN

(21) Numéro de dépôt: **89402609.5**

(22) Date de dépôt: **22.09.89**

(51) Int. Cl.5: **G 01 R 31/26**
**H 01 P 5/12**

(30) Priorité: **23.09.88 FR 8812482**

(43) Date de publication de la demande:
**28.03.90 Bulletin 90/13**

(84) Etats contractants désignés: **DE GB NL**

(71) Demandeur: **CENTRE NATIONAL DE LA RECHERCHE SCIENTIFIQUE (CNRS)**
**15, Quai Anatole France**
**F-75700 Paris Cedex 07 (FR)**

(72) Inventeur: **Bourzgui, Nour-Eddine**
**CABINET BALLOT-SCHMIT 7, Rue Le Sueur**
**F-75116 Paris (FR)**

**Constant, Eugène**
**CABINET BALLOT-SCHMIT 7, Rue Le Sueur**
**F-75116 Paris (FR)**

**Druon, Christian**
**CABINET BALLOT-SCHMIT 7, Rue Le Sueur**
**F-75116 Paris (FR)**

**Tabourier, Pierre**
**CABINET BALLOT-SCHMIT 7, Rue Le Sueur**
**F-75116 Paris (FR)**

**Wacrenier, Jean-Marie**
**CABINET BALLOT-SCHMIT 7, Rue Le Sueur**
**F-75116 Paris (FR)**

(74) Mandataire: **Ballot, Paul Denis Jacques**
**Cabinet Ballot-Schmit 7, rue le Sueur**
**F-75116 Paris (FR)**

(54) **Sonde de mesure d'effets magnétoélectriques et procédé correspondant.**

(57) L'invention concerne la mesure d'effets magnétoélectriques, et plus particulièrement la mesure d'effets magnétoélectriques dans des échantillons de matériau semiconducteur.

On propose une sonde de mesure d'effets magnétoélectriques, caractérisée en ce qu'elle comporte un plan métallique recouvert d'un substrat (10) ayant une surface électriquement conductrice et une surface supérieure électriquement isolante comportant quatre électrodes (12, 14, 16, 18) ayant chacune une extrémité libre, les extrémités libres des électrodes se faisant vis-à-vis et étant séparées les unes des autres par un espace libre, les extrémités des électrodes et éventuellement l'espace libre étant recouverts d'une couche diélectrique (36). On applique un échantillon (40) de matériau semiconducteur sur cette sonde et on applique à l'échantillon par couplage capacitif un courant hyperfréquence sur une des électrodes; on lit le signal résultant, en présence d'un champ magnétique, sur les trois autres électrodes.

FIG_3

EP 0 360 700 A1

Description

## SONDE DE MESURE D'EFFETS MAGNETOELECTRIQUES ET PROCEDE CORRESPONDANT

L'invention concerne la mesure d'effets magnétoélectriques, et plus particulièrement la mesure d'effets magnétoélectriques dans des échantillons de matériau semiconducteur.

Les mesures d'effets magnétoélectriques permettent en effet de déterminer des grandeurs physiques telles que la densité de porteurs de charge libres dans un matériau semiconducteur, ainsi que la mobilité de ces porteurs. La connaissance de ces grandeurs, ou la connaissance de leurs variations avec la température, est importante dans l'industrie des semiconducteurs. Les circuits intégrés sont en effet conçus en fonction de certaines données physiques de base et il est important que les matériaux utilisés pour réaliser ces circuits aient des caractéristiques physiques bien déterminées. La mesure magnétoélectrique de base est la mesure de l'effet Hall, c'est-à-dire la mesure d'une différence de potentiel apparaissant perpendiculairement à la direction de passage d'un courant dans un échantillon lorsque l'échantillon est placé dans un champ magnétique.

D'autres mesures magnétoélectriques, c'est-à-dire des mesures de tensions ou courants en présence de champs magnétiques sont possibles et renseignent sur certaines caractéristiques physique de l'échantillon.

Il est apparu la nécessité d'améliorer les dispositifs de mesures d'effets magnétoélectriques, les dispositifs existants ne donnant pas entièrement satisfaction, notamment pour les mesures d'échantillons de matériaux semiconducteurs dans l'industrie des circuits intégrés. En effet, les échantillons peuvent être très petits (il peut s'agir de puces pour la fabrication de circuits intégrés), ce qui rend la mesure plus difficile; par ailleurs, on souhaite que la mesure soit non destructive et qu'elle détériore aussi peu que possible la surface des échantillons sur lesquels elle est effectuée. Enfin, on veut que l'appareil de mesure soit simple et facile à utiliser. Les appareils existants ne donnent pas satisfaction sur l'ensemble de ces points.

On propose selon l'invention une sonde de mesure particulièrement simple et commode d'utilisation, et un procédé de mesure correspondant, qui ne souffre pas des inconvénients de la technique antérieure.

De manière générale, la sonde de mesure d'effets magnétoélectriques selon l'invention comporte un substrat ayant une surface inférieure électriquement conductrice et, une surface supérieure électriquement isolante recouverte de quatre électrodes ayant chacune une extrémité libre, les extrémités libres des électrodes se faisant vis-à-vis et étant séparées les unes des autres par un espace libre, les extrémités des électrodes étant recouvertes d'une couche diélectrique, ainsi éventuellement que l'espace libre.

La mesure consiste à appliquer l'échantillon à mesurer contre une telle sonde, appliquer un signal hyperfréquence sur une des électrodes, et faire une mesure de signal au moins une des autres électrodes. En pratique, la sonde selon l'invention comportera un substrat dont la surface inférieure est métallique et dont la surface supérieure est essentiellement plane et électriquement isolante, quatre électrodes indépendantes les unes des autres déposées sur la surface supérieure du substrat et susceptibles d'être reliées individuellement chacune à une borne de connexion respective d'entrée et/ou sortie de signal de la sonde, un espace libre de conducteurs déposés étant ménagé dans la partie centrale du substrat, les extrémités de deux électrodes se faisant vis-à-vis de part et d'autre de cet espace selon une première direction d'alignement, et les extrémités des deux autres électrodes se faisant vis-à-vis de part et d'autre de l'espace libre selon une deuxième direction perpendiculaire à la première, une couche diélectrique étant déposée sur les extrémités en vis-à-vis des quatre électrodes, les positions des extrémités des électrodes étant choisies en rapport avec la dimension des échantillons à mesurer pour que l'échantillon puisse être appliqué sur la couche diélectrique en recouvrant simultanément les extrémités en vis-à-vis des quatre électrodes.

Dans une variante, la couche diélectrique recouvre également l'espace libre entre les extrémités libres des électrodes.

Les électrodes sont de préférence des lignes microruban telles qu'on en utilise couramment dans les circuits hyperfréquence et leur impédance caractéristique est de préférence de 50 ohms.

L'invention se prête particulièrement bien à la mesure d'effets magnétoélectriques aussi bien sur des tranches entières de semiconducteur que sur des puces individuelles pour élaboration de circuits intégrés. La sonde servira par exemple à mesurer le dopage et la mobilité de couches épitaxiées sur des substrats semiconducteurs. Elle permet aussi de tracer de véritables cartographies de Hall sur des échantillons de grandes dimensions.

D'autres caractéristiques et avantages de l'invention apparaîtront à la lecture de la description détaillée qui suit et qui est faite en référence aux dessins annexés dans lesquels :

- la figure 1 représente une vue de dessus de la sonde selon l'invention,
- la figure 2 représente une coupe latérale correspondante selon la ligne II-II de la figure 1;
- la figure 3 représente une vue de dessus de la sonde avec un échantillon mis en place sur la sonde;
- la figure 4 représente une coupe latérale selon la ligne IV-IV de la figure 3.

Sur les figures, les échelles ne sont pas respectées pour la commodité de la représentation.

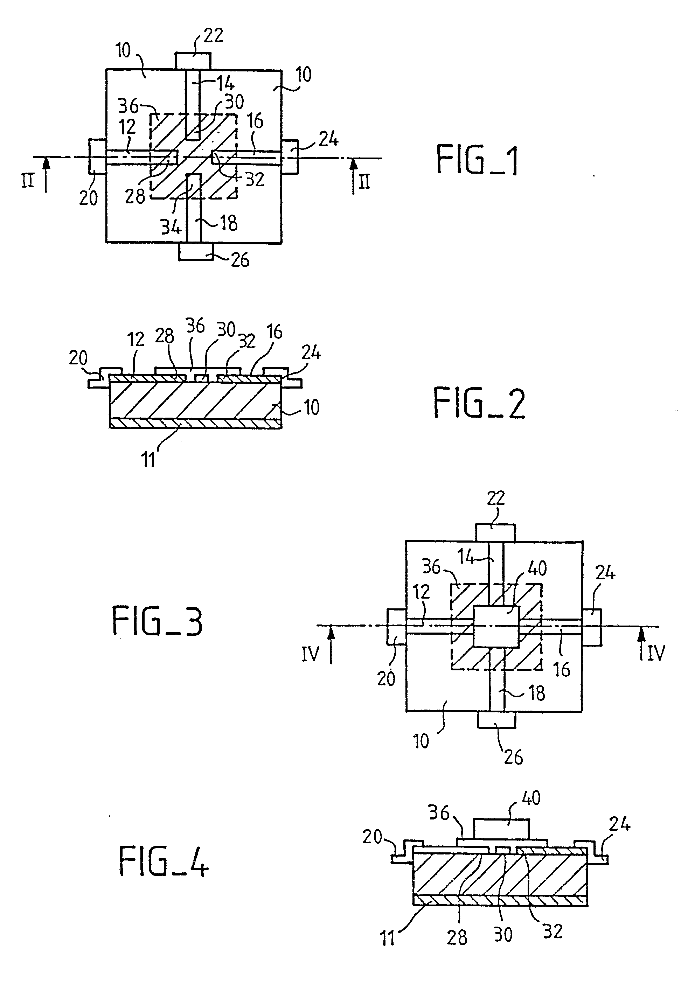

La sonde de la figure 1 comprend un substrat isolant 10 dont la surface inférieure est électriquement conductrice et représentée par une couche ou plan métallique 11 et dont la surface supérieure est isolante. Le substrat 10 est, par exemple de l'alumine, généralement polie, et sa nature et son épaisseur sont choisies en fonction de la largeur d'électrodes dont il sera question ci-après de manière à réaliser des lignes de transmission dont l'impédance caractéristique est fixée.

Le plan métallique (11) de la surface inférieure du substrat (10) est utilisé comme connexion électrique de masse. La surface supérieure du substrat (10), c'est-à-dire la surface qui sera appliquée contre un échantillon à mesurer, est essentiellement plane.

Des électrodes conductrices sont déposées sur cette surface supérieure. Il y a quatre électrodes, respectivement 12, 14, 16, 18 aboutissant chacune à une borne de connexion respective 20, 22, 24, 26 et ayant chacune par ailleurs une extrémité libre respective 28, 30, 32, 34.

Les quatre électrodes sont indépendantes les unes des autres (non reliées entre elles) et les bornes de connexion 20, 22, 24, 26 servent à l'application de signaux d'entrée/sortie à la sonde, à partir d'un appareil de mesure non représenté.

Les extrémités libres des électrodes sont disposées à des emplacements qui constitueront des points d'entrée et de sortie de signal hyperfréquence lors de la mesure. Par conséquent, en fonction de la nature et la dimension des échantillons à mesurer, on prévoira la position des extrémités libres 28 à 34 de la sonde.

Les extrémités libres des quatre électrodes sont en vis-à-vis les unes des autres, séparées par un espace libre central. Les extrémités libres de deux des électrodes (12 et 16) sont en vis-à-vis de part et d'autre de l'espace libre central et définissent une première direction d'alignement. Les extrémités libres des deux autres électrodes (14 et 18) sont aussi en vis-à-vis et définissent une autre direction d'alignement perpendiculaire à la première.

Dans l'exemple décrit ici, les tronçons d'électrodes opposés sont alignés l'un avec l'autre : il y a deux tronçons de conducteurs (12 et 16) alignés dans la première direction définie par l'alignement de leurs extrémités, et deux autres tronçons (14 et 18), alignés dans la direction perpendiculaire.

Les électrodes sont de préférence réalisées sous forme de lignes microruban telles qu'on les utilise usuellement dans les techniques de circuits hybrides hyperfréquences. Leur impédance caractéristique est de préférence 50 ohms. Les conducteurs sont déposés par sérigraphie d'une pâte conductrice, ou bien ils sont déposés par évaporation d'un métal sous vide puis photogravés. Le métal est de préférence de l'or. Leur largeur est à titre d'exemple de 600 micromètres.

Une couche diélectrique 36 est déposée sur la surface supérieure du substrat au-dessus de ces extrémités libres d'électrodes, et éventuellement au-dessus de la totalité de l'espace libre entre les extrémités libres des électrodes comme cela est représenté sur les figures 1 à 4.

Cette couche 36 est très mince de manière qu'une transmission de signal capacitive soit possible entre les extrémités des conducteurs de la sonde et l'échantillon à mesurer qui sera appliqué contre la sonde.

A titre d'exemple, la couche diélectrique est une couche d'oxyde de silicium $SiO_2$ déposée par décomposition chimique en phase gazeuse sur une épaisseur d'environ 2000 angströms.

La couche peut être déposée uniformément sur tout le substrat ou uniquement sur une surface un peu plus large que la dimension des échantillons à mesurer.

A titre d'exemple, la dimension du substrat peut être de 2,5 cm sur 2,5 cm environ, la dimension des échantillons de 3 mm sur 3 mm environ, la largeur de l'espace libre distance entre les extrémités libres des électrodes opposées) de 1,8 mm environ en largeur comme en longueur; la surface recouverte d'oxyde de silicium peut être de 5 mm sur 5 mm; elle inclut de toutes façons les quatre extrémités libres d'électrodes et éventuellement, la totalité de l'espace libre entre ces extrémités.

A la figure 3 (en vue de dessus), et à la figure 4 (en coupe latérale), on a représenté la sonde avec un échantillon en cours de mesure. L'échantillon est appliqué par pression contre la surface supérieure de la sonde et recouvre les extrémités libres des quatre électrodes. Il repose sur la couche diélectrique 36 qui l'isole des conducteurs et du substrat. Les références sont les mêmes qu'aux figures 1 et 2; l'échantillon est désigné par la référence 40. L'échantillon est par exemple un morceau de silicium ou d'arseniure de gallium dont on veut mesurer la résistivité ou le dopage ou la mobilité des porteurs de charge.

La mesure consiste à appliquer un signal à haute fréquence à l'une des électrodes et à lire la transmission qui en résulte, en général sur les trois autres électrodes, alors que la sonde et l'échantillon appliqué contre elle sont placés dans un champ magnétique dont on connaît les caractéristiques.

Le plus fréquemment, le champ magnétique sera continu, on appliquera un signal sur l'une des électrodes, et on lira le signal induit sur les trois autres électrodes, la couche métallique 11 servant d'électrode de masse.

Le signal d'entrée étant à haute fréquence, il est transmis à l'échantillon à travers la capacité formée par le recouvrement entre l'échantillon et les extrémités des électrodes en vis-à-vis. L'impédance de cette capacité à la fréquence considérée est négligeable devant la résistance de l'échantillon dans la zone recouvrant l'espace libre entre les électrodes. De même, le signal de sortie est aussi un signal haute fréquence transmis de l'échantillon aux trois électrodes de sortie par couplage capacitif, la perturbation apportée par l'impédance de la capacité étant négligeable à la fréquence considérée.

A titre d'exemple, la fréquence peut être de environ 1 à 2 gigahertz.

On injecte donc un courant à haute fréquence sur l'une des électrodes par couplage capacitif, et on lit, également par couplage capacitif, les signaux à haute fréquence apparaissant sur les autres électrodes. Seuls sont mesurés les modules des coefficients de transmission de signal d'une électrode à l'autre, les phases ne sont pas mesurées, ce qui entraîne une grande simplification de l'appareil de mesure.

Si on veut tenir compte dans la mesure du fait que les capacités de couplage entre les électrodes et l'échantillon ne présentent pas une impédance rigoureusement nulle, on peut procéder au préalable à une mesure de ces capacités pour l'échantillon en cours de mesure afin d'en tenir compte et d'obtenir des résultats plus précis.

La mesure peut consister tout simplement en une mesure d'impédance à basse fréquence entre deux électrodes opposées, en l'absence de champ magnétique: on applique un courant d'entrée en basse fréquence entre deux électrodes opposées, les autres étant non connectées, et on lit la tension présente entre les électrodes; on en déduit l'impédance, donc la capacité. Par basse fréquence, on entend ici une fréquence suffisamment basse pour que la résistance de l'échantillon constitue une impédance négligeable devant celle des capacités de couplage, mais suffisamment haute pour que l'impédance des capacités de liaison soit quand même mesurable. Par exemple, pour un échantillon dont la résistance par carré est de l'ordre de quelques ohms à quelques milliers d'ohms, et si les capacités de liaison sont de l'ordre de la dizaine de picofarads, une fréquence de l'ordre du mégahertz convient bien et permet une détermination précise des capacités. Un ensemble de mesures redondantes peut être fait pour améliorer la précision de cette mesure.

Pour la mesure d'effet Hall en hyperfréquence selon l'invention, on procédera plus précisément de la manière suivante: on injecte un courant hyperfréquence sur une électrode à une fréquence suffisamment grande pour que la perturbation apportée par les capacités de liaison soit assez faible, mais suffisamment petite pour que les impédances présentes puissent être considérées comme à constantes localisées. On choisira une fréquence telle que l'impédance des capacités soit faible devant la résistance par carré de l'échantillon et telle cependant que la longueur d'onde de l'onde hyperfréquence dans les lignes microruban constituant les électrodes soit au moins dix fois supérieure aux dimensions de l'échantillon. Une fréquence de 1 à 2 gigahertz convient bien.

Comme dans les mesures d'effet Hall classiques (en courant continu), on déterminera la résistance par carré en l'absence et en présence de champ magnétique par mesure de différence de potentiel entre deux électrodes opposées alors qu'un courant est injecté entre ces deux électrodes, les deux autres étant connectées sur une impédance très grande. Puis on déterminera la constante de Hall à partir de la mesure de coefficients de transmission de signal entre les différents couples d'électrodes, d'abord en l'absence puis en présence de champ magnétique.

De manière générale, la taille de l'échantillon et la fréquence de travail sont choisies en fonction d'un compromis permettant d'avoir
- des impédances capacitives petites par rapport à la résistance par carré de l'échantillon;
- des conditions de mesure telles que l'échantillon puisse être considéré comme un système à constantes localisées (et non à constantes réparties, ce qui rendrait l'exploitation des résultats de mesure plus délicate).

Il est possible alors de mesurer des échantillons ayant des résistances de l'ordre de quelques ohms par carré à quelques kilohms par carré, des dopages de l'ordre de $10^{16}$ à quelques $10^{18}$ atomes par cm$^3$, et des mobilités de l'ordre de $10^3$ à $10^5$ cm$^2$/V.s.

Ces plages de valeur correspondent tout-à-fait aux situations pratiques dans l'industrie des semiconducteurs.

On notera que la disposition à symétrie carrée des électrodes de la sonde permet de faire des mesures redondantes en utilisant tour à tour différentes d'électrodes comme électrode d'entrée de signal, et en faisant la moyenne des résultats obtenus.

La sonde selon l'invention peut fonctionner à des températures très variables, y compris à des températures très basses de l'ordre de -200°C.

Dans une réalisation, on pourra prévoir que l'échantillon est placé directement sur la sonde dont la position est fixe. Dans une autre réalisation, la sonde est mobile et peut être déplacée par un automate de positionnement sur un échantillon de grande taille pour en faire une cartographie de dopages, résistivité, mobilité; l'échantillon est alors par exemple une tranche entière de semiconducteur de quatre à huit pouces de diamètre comme on en utilise dans l'industrie des semiconducteurs.

Dans tous les cas, les mesures sont rapides et ne nécessitent pas un traitement technologique préalable des échantillons. Les échantillons ne sont pas détériorés et peuvent être contrôlés à plusieurs stades d'un processus industriel de fabrication de circuits intégrés: avant épitaxie, après épitaxie, après des opérations d'implantations ioniques, de recuits, etc.

**Revendications**

1. Sonde de mesure d'effets magnétoélectriques, caractérisée en ce qu'elle comporte un substrat isolant (10) ayant une surface inférieure électriquement conductrice (11) et une surface supérieure électriquement isolante recouverte de quatre électrodes (12, 14, 16, 18) ayant chacune une extrémité libre, les extrémités libres des électrodes se faisant vis-à-vis et étant séparées les unes des autres par un espace libre, les extrémités libres (28, 30, 32, 34) des électrodes (12, 14, 16, 18) étant recouvertes d'une couche diélectrique (36).

2. Sonde de mesure d'effets magnétoélectriques, caractérisée en ce qu'elle comporte un substrat isolant (10) dont la surface inférieure (11) est électriquement conductrice et dont la surface supérieure est essentiellement plane et électriquement isolante, quatre électrodes indépendantes (12, 14, 16,18) les unes des autres déposées sur la surface supérieure du substrat (10) et susceptibles d'être reliées individuellement chacune à une borne de connexion (20, 22, 24, 26) respective d'entrée et/ou sortie de signal de la sonde, un espace libre de conducteurs déposés étant ménagé dans la partie centrale du substrat (10), les extrémités (28, 32) de deux électrodes (12, 16) se faisant vis-à-vis de part et d'autre de cet espace selon une première direction d'alignement, et les extrémités (30, 34) des deux autres électrodes (14, 18) se faisant vis-à-vis de part et d'autre de l'espace libre selon une deuxième direction perpendiculaire à la première, une couche diélectrique (36) étant déposée au moins sur les extrémités (28, 30, 32, 34) en vis-à-vis des quatre électrodes, les positions des extrémités des électrodes étant choisies en rapport avec la dimension des échantillons (40) à mesurer pour que l'échantillon puisse être appliqué sur la couche diélectrique (36) en recouvrant simultanément les extrémités (28, 30, 32, 34) en vis-à-vis des quatre électrodes (12, 14, 16, 18).

3. Sonde selon la revendication 1 ou 2, caractérisée en ce que la couche diélectrique (36) recouvre également tout l'espace libre entre les extrémités libres (28, 30, 32, 34) des électrodes (12, 14, 16, 18).

4. Sonde selon la revendication 1,2 ou 3, caractérisée en ce que les électrodes (12, 14, 16, 18) sont des lignes microruban.

5. Sonde selon l'une des revendications 1 à 4, caractérisée en ce que les électrodes (12, 14, 16, 18) sont disposées suivant une symétrie carrée.

6. Procédé de mesure d'effets magnétoélectriques dans un échantillon, caractérisé en ce que:
- on applique l'échantillon (40) à mesurer contre une sonde constituée par un substrat isolant (10) ayant une surface inférieure métallique (11) et une surface supérieure isolante recouverte de quatre électrodes (12, 14, 16, 18) ayant chacune une extrémité libre (28, 30, 32, 34), les extrémités libres (28, 30, 32, 34) des électrodes (12, 14, 16, 18) se faisant vis-à-vis et étant séparées les uns des autres par un l'espace libre et les extrémités (28, 30, 32, 34) des électrodes et éventuellement l'espace libre entre elles étant recouverts d'une couche diélectrique (36), l'échantillon (40) étant appliqué contre la couche diélectrique (36) de la sonde en recouvrant simultanément les extrémités (28, 30, 32, 34) des quatre électrodes (12, 14, 16, 18),
- on applique un signal hyperfréquence sur une des électrodes, et
- on fait une mesure de signal sur au moins une des trois autres électrodes.

FIG_1

FIG_2

FIG_3

FIG_4

| | | | |
|---|---|---|---|
| Office européen<br>des brevets | **RAPPORT DE RECHERCHE EUROPEENNE** | Numero de la demande | |
| | | EP 89 40 2609 | |

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (Int. Cl.5) |
|---|---|---|---|
| Y | EP-A-0 217 478 (STICHTING CENTRUM VOOR MICRO-ELEKTRONICA TWENTE)<br>* Figure 2 * | 1,3-5 | G 01 R 31/26<br>H 01 P 5/12 |
| A | --- | 2,6 | |
| Y | FREQUENZ, vol. 39, no. 4, avril 1985, pages 99-107, Berlin, DE; J. SIEGL et al.: "Entwurf und Optimierung von planaren Richtkopplern mit verbesserter Richtwirkung"<br>* Figure 1C * | 1,3-5 | |
| A | IDEM<br>--- | 2,6 | |
| A | SOLID-STATE ELECTRONIC, vol. 27, no. 10, octobre 1984, pages 881-891, Pergamon Press Ltd. Elmsford, New Jersey, US; R.S. NAKHMANSON et al.: "Investigations of metal-insulator-semiconductor structure inhomogeneities using a small-size mercury probe"<br>* Figure 1 *<br>----- | 2,6 | **DOMAINES TECHNIQUES RECHERCHES (Int. Cl.5)**<br><br>G 01 D<br>G 01 R<br>H 01 P |

Le présent rapport a été établi pour toutes les revendications

| Lieu de la recherche | Date d'achèvement de la recherche | Examinateur |
|---|---|---|
| LA HAYE | 14-11-1989 | LUT K. |